# EUROPÄISCHE PATENTANMELDUNG

(11) **EP 2 940 702 A1**
(43) Veröffentlichungstag der Anmeldung: **04.11.2015**
(21) Anmeldenummer: 15163190.0
(22) Anmeldetag: 10.04.2015
(51) Int. Cl.: H01F 38/30, G01R 15/20

(54) **DIFFERENZSTROM-MESSMODUL**

(30) Priorität: 16.04.2014 DE 102014005538
(71) Anmelder: Bender GmbH & Co. KG, 35305 Grünberg (DE)
(72) Erfinder: Möll, Winfried, 35321 Laubach (DE); Kammer, Michael, 35410 Hungen (DE); Prinz-Weinel, Michael, 63691 Ranstadt (DE)
(74) Vertreter: advotec.

(57) **Zusammenfassung**

Die Erfindung betrifft ein Differenzstrom-Messmodul bestehend aus einem Gehäuse, das einen Stromwandlerkern und eine Leiterplatine umgibt, wobei der Stromwandlerkern eine Leitungsdurchführung des Gehäuses umschließt und mindestens eine Sekundärwicklung aufweist. Das Differenzstrom-Messmodul zeichnet sich dadurch aus, dass in der Leitungsdurchführung mindestens ein Primärleiter angeordnet ist, der zum Anschluss an eine äußere elektrische Zuleitung auf einer Oberseite des Gehäuses herausgeführt ist und dessen anderes Ende aus einer Gehäuseunterseite herausragt und mit einem Lötanschluss versehen ist. Der Grundgedanke der vorliegenden Erfindung beruht darauf, die zu überwachende elektrische Leitung als Primärleiter im Wirkungsbereich des Stromwandlerkerns abschnittsweise so weiterzuführen, dass in vorteilhafter Weise ein konstruktiv einfacher Einbau einer Differenzstrom-Messeinrichtung mit unkomplizierter Anschlussmöglichkeit gegeben ist.

## Beschreibung

Die Erfindung betrifft ein Differenzstrom-Messmodul bestehend aus einem Gehäuse, das einen Stromwandlerkern und eine Leiterplatine umgibt, wobei der Stromwandlerkern eine Leitungsdurchführung des Gehäuses umschließt und mindestens eine Sekundärwicklung aufweist.

Zur Überwachung und zum Schutz elektrischer Anlagen sind Messvorrichtungen wie beispielsweise Differenzstrom-Überwachungsgeräte (RCMs) oder Fehlerstrom-Schutzeinrichtungen (RCDs) hinlänglich bekannt.

Diese bekannten Verfahren und Vorrichtungen beruhen überwiegend auf dem Prinzip der galvanisch getrennten Differenzstrommessung, bei dem alle aktiven Leiter einer zu überwachenden elektrischen Leitung als Primärwicklung (Primärleiter) durch einen Messstromwandler mit einem ringförmigen Stromwandlerkern aus ferromagnetischem Material und mit mindestens einer Sekundärwicklung geführt werden. Der Stromwandlerkern ist in der Regel in einem Gehäuse verbaut, das eine Leitungsdurchführung für die zu überwachende Zuleitung aufweist, wobei der Stromwandlerkern die Leitungsdurchführung ringförmig umschließt.

Derartige Messvorrichtungen werden auch zur Lichtbogenerkennung in elektrischen Anlagen sowie in zunehmendem Maße zur Überwachung und zum Schutz von Ladeeinrichtungen bei der Aufladung von Energiespeichern in Elektrofahrzeugen eingesetzt. Beispielsweise schreibt die Norm IEC 62752 vor, dass in einem IC-CPD (In-Cable Control and Protection Device) der Ladevorgang mit einer Differenzstromsensorik für einphasige und dreiphasige Ladeinrichtungen überwacht werden muss. Dabei muss die Differenzstrom-Messeinrichtung in der Lage sein, je nach Lademodus unterschiedliche Stromstärken, beispielsweise 3 x 32A oder 2 x 80A, verarbeiten zu können. Hinzu kommen weitere Anforderungen hinsichtlich der Erkennung eines Gleich-Fehlerstroms.

Bislang werden zur Erfüllung der normativ gestellten Anforderungen aus dem Stand der Technik bekannte RCMs eingesetzt, die den Differenzstrom, gegebenenfalls allstromsensitiv, messen. Bei Ladeeinrichtungen für Elektrofahrzeuge können RCDs vom Typ B oder besondere RCDs mit einer 6mA-Überwachung verwendet werden.

Als Nachteil bei dem Einsatz bekannter Differenzstrom-Messvorrichtungen erweist sich deren konstruktiv aufwändige Integration in elektrische Installationen, beispielsweise in eine Ladevorrichtung mit integrierter Steuer- und Schutzeinrichtung, da die Primärleiter in oftmals beengten Bauräumen durch den Stromwandler hindurchgeführt und in aufwändiger Weise kostenintensiv per Hand auf einer Montage-Leiterplatte verdrahtet werden müssen.

Der vorliegenden Erfindung liegt somit die Aufgabe zu Grunde, eine Differenzstrom-Messeinrichtung zu schaffen, die in konstruktiv einfacher Weise und damit kostengünstig in elektrische Installationen integrierbar ist.

Diese Aufgabe wird in Verbindung mit dem Oberbegriff des Anspruchs 1 dadurch gelöst, dass in der Leitungsdurchführung mindestens ein Primärleiter angeordnet ist, der zum Anschluss an eine äußere elektrische Zuleitung auf einer Oberseite des Gehäuses herausgeführt ist und dessen anderes Ende aus einer Gehäuseunterseite herausragt und mit einem Lötanschluss versehen ist.

Der Grundgedanke der vorliegenden Erfindung beruht darauf, die zu überwachende elektrische Leitung als Primärleiter im Wirkungsbereich des Stromwandlerkerns abschnittsweise so weiterzuführen, dass in vorteilhafter Weise ein konstruktiv einfacher Einbau einer Differenzstrom-Messeinrichtung mit unkomplizierter Anschlussmöglichkeit möglich ist.

Der an der Oberseite des Gehäuses herausgeführte Primärleiter ermöglicht die elektrische Verbindung mit der zu überwachenden Zuleitung, so dass ein Hindurchführen dieser Zuleitung durch den Stromwandlerkern nicht notwendig ist. Insbesondere bei wenig zur Verfügung stehendem Bauraum werden die Installation und die Einbindung einer Differenzstrom-Messeinrichtung erheblich erleichtert.

Ohne aufwändige Montagearbeiten und ohne weiteren Verdrahtungsaufwand ist es lediglich erforderlich, die zu überwachende Zuleitung an den an der Oberseite des Gehäuses herausgeführten Primärleiter anzuschließen.

An seinem gegenüberliegenden Ende ragt der Primärleiter über die Unterseite des Gehäuses heraus und ist mit einem Lötanschluss versehen. Bei der Montage des Differenzstrom-Messmoduls auf einer Montage-Leiterplatte kann dieser Lötanschluss mit Lötkontakten (Lötpads) auf der Montage-Leiterplatte verbunden werden, so dass in einfacher Weise eine elektrische Verbindung der zu überwachenden Zuleitung mit einer nachfolgenden elektrischen Schaltung gewährleistet ist. Auf der Montage-Leiterplatte ist keine weitere Leitungsführung erforderlich.

Aufgrund der kompakten Bauweise eignet sich das erfindungsgemäße Differenzstrom-Messmodul insbesondere für den Einsatz in Betriebsumgebungen mit beschränktem Bauraum, wie beispielsweise in Ladeeinrichtungen und Ladekabeln für Elektrofahrzeuge zur Detektion von Fehlerströmen. Ebenso zweckmäßig ist die Verwendung als ein- oder mehrphasige Differenzstromsensorik für Fotovoltaik-Wechselrichter, integriert in eine AC-Wechselrichter-Anschlusskontaktleiste oder in Frequenzumrichtern zur Reglung elektrischer Antriebe.

In weiterer vorteilhafter Ausgestaltung ist in der Leitungsdurchführung ein parallel zu der Leitungsdurchführung verlaufender Trennsteg zur Abstandshaltung des Primärleiters angeordnet.

Der Trennsteg separiert den einzelnen Primärleiter und führt dadurch zu einer Reduzierung der Luft- und Kriechstrecken. Durch den Trennsteg kann bei minimalem Abstand des Primärleiters zu anderen elektrisch leitfähigen Bauelementen oder zu benachbarten Primärleitern die Einhaltung der Isolationsanforderungen sichergestellt werden. Darüber hinaus ermöglicht der Trennsteg die Verwendung eines Primärleiters ohne eigene Isolierung oder Umspritzung.

Weiterhin besteht der in der Leitungsdurchführung angeordnete Trennsteg aus vier kreuzförmig zueinander angeordneten Stegwänden, so dass die Leitungsdurchführung in vier getrennte Leiterkanäle aufgeteilt ist, in denen jeweils ein Primärleiter isoliert geführt ist.

In Verbindung mit einer elektrischen Zuleitung, die vier aktive Leiter (die Phasenleiter L1, L2, L3 und den Neutralleiter N) umfasst, können diese aktiven Leiter durch die vier Stegwände des kreuzförmig ausgebildeten Trennstegs isoliert voneinander in getrennten Leiterkanälen geführt werden.

Der Trennsteg ragt vorteilhaft über die Oberseite des Gehäuses hinaus, sodass der Primärleiter oberhalb des Gehäuses isoliert nach außen gerichtet weiterführbar ist.

Die Verlängerung des Trennsteges über die Oberseite des Gehäuses hinaus gewährleistet auch die Separierung des Primärleiters bei einer Weiterführung des Primärleiters aus dem Gehäuse. Insbesondere bei einer mehrphasigen Zuleitung mit vier aktiven Leitern ermöglicht der über die Oberseite des Gehäuses hinausragende und kreuzförmig ausgebildete Trennsteg eine kreuzförmige, nach außen gerichtete und damit im Sinne der Isolationsanforderungen sichere Weiterführung der Primärleiter.

Weiterhin ragt der Trennsteg über die Unterseite des Gehäuses hinaus.

Bei der Montage des Differenzstrom-Moduls auf einer Montage-Leiterplatte kann der über die Unterseite des Gehäuses hinausragende Trennsteg in eine Schlitzung der Montage-Leiterplatte eingreifen. Somit ist auch eine hinreichende Abstandshaltung der Primärleiter beim Austritt an der Gehäuseunterseite gewährleistet.

In weiterer Ausgestaltung ist der Trennsteg als separates, in die Leitungsdurchführung des Gehäuses einsetzbares und herausnehmbares Bauteil ausgeführt.

Die Ausführung des Trennsteges als separates Bauteil ermöglicht es, das Differenzstrom-Messmodul flexibel mit oder ohne Trennsteg zu verwenden. Beispielsweise kann bei Verwendung von Primärleitern mit eigener hinreichender Isolierung auf das Einsetzen eines Trennsteges verzichtet werden.

Mit Vorteil sind an der Oberseite des Gehäuses Klemmvorrichtungen zur Befestigung des rechtwinklig aus der Leitungsdurchführung herausgeführten Primärleiters angebracht.

Die Klemmvorrichtungen können beispielsweise als Schnappelemente ausgeführt sein und bewirken eine Fixierung des/der an der Gehäuseoberseite nahezu rechtwinklig herausgeführten Primärleiter(s). Im Falle der mehrphasigen Zuleitung mit vier aktiven herausgeführten Leitern werden diese durch die Klemmvorrichtungen in kreuzförmiger Anordnung an der Gehäuseoberfläche fixiert.

Weiterhin weist die Leitungsdurchführung des Gehäuses an der Unterseite des Gehäuses eine kegelförmige Aufweitung auf, sodass die Primärleiter radial nach außen abgewinkelt mit vergrößertem Abstand positionierbar sind

Die kegelförmige Aufweitung der Leitungsdurchführung an der Gehäuseunterseite ermöglicht eine radial nach außen abgewinkelte Verlegung der Primärleiter. Dadurch sind die Abstände zwischen den Lötanschlüssen auf der Montage-Leiterplatte größer und die Luft- und Kriechstrecken sind in vorteilhafter Weise länger.

Das Gehäuse weist ein Gehäuseoberteil und ein Gehäuseunterteil auf, die mittels einer Rastverbindung miteinander verbindbar sind. In alternativer Ausgestaltung kann das Gehäuse ein einteiliges vergossenes Gehäuse sein.

In bevorzugter Ausführung ist der Stromwandlerkern zur gehäuseinternen Positionierung auf Stützauflagen gelagert.

Durch die Positionierung des Stromwandlerkerns auf Stützauflagen ist unterhalb des Stromwandlerkerns zwischen Gehäuseboden und dem Stromwandlerkern Bauraum vorhanden, um die Leiterplatine mit darauf angeordneten elektronischen Bauelementen anzuordnen.

In einer zweckmäßigen Ausgestaltung sind von einer auf der Leiterplatine angeordneten Auswerteschaltung erzeugte Ausgangssignale über Stiftkontakte an der Unterseite des Gehäuses herausgeführt.

Die auf der Leiterplatine angeordnete Auswerteschaltung ist ein integraler Bestandteil des Differenzstrom-Moduls. Zur Weiterverarbeitung der in der Auswerteschaltung erzeugten Ausgangssignale sind diese Ausgangssignale über in den Gehäuseboden eingelassene Stiftkontakte nach außen geführt und werden so beispielsweise auf eine Montage-Leiterplatte übertragen, auf die das Differenzstrom-Messmodul montiert ist. Die die Auswerteschaltung tragende Leiterplatine kann auch als flexible Leiterplatte (FPC - Flexible Printed Circuit) ausgeführt sein und platzsparend um den Stromwandlerkern geformt sein. Möglich ist auch eine Anbringung der Auswerteelektronik innerhalb eines den Stromwandlerkern umgebenden Wandlerschirmgehäuses.

Bevorzugt ist der Primärleiter an dem an der Oberseite des Gehäuses herausgeführten Ende mit einem Steckkontakt versehen.

Die Steckkontaktierung erlaubt ohne Zuhilfenahme weiterer Verbindungselemente eine schnelle Herstellung einer lösbaren elektrischen Verbindung mit der zu überwachenden Zuleitung.

In einer weiteren bevorzugten Ausgestaltung ist der mit dem Steckkontakt versehene Primärleiter als separate, in die Leitungsdurchführung des Gehäuses einsetzbare und herausnehmbare bauliche Einheit ausgeführt.

In dieser Ausführung besteht das Differenzstrom-Messmodul aus dem Gehäuse, in dessen Leitungsdurchführung die mit dem Steckkontakt versehenen Primärleiter als separate bauliche Einheit einsetzbar sind. Ist zudem ein Trennsteg vorhanden, so kann dieser ebenfalls Bestandteil der separaten baulichen Einheit sein.

Somit bietet sich die Möglichkeit, das Differenzstrom-Messmodul auch ohne Primärleiter-Steckkontakt-Einsatz beispielsweise mit einer durch die Leitungsdurchführung hindurchgeführten Zuleitung als Primärleiter zu betreiben.

Weiter weist das Differenzstrom-Messmodul ein Steckergehäuse auf, durch das die Steckkontakte der Primärleiter hindurchragen und mit einem Gegenstecker kontaktiert werden können.

Das Gehäuse selbst kann als Steckergehäuse geformt sein oder von einem zusätzlichen Steckergehäuse umgeben sein, wobei die Steckkontakte der Primärleiter die elektrische Kontaktierung nach außen herstellen.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: eine Außenansicht eines erfindungsgemäßen Differenzstrom-Messmoduls,
- **Fig. 2:**: einen Innenaufbau des Differenzstrom-Messmoduls,
- **Fig. 3:**: eine Detailansicht der Stützauflagen,
- **Fig. 4:**: eine Variante des Differenzstrom-Messmoduls mit zylindrischer Leitungsdurchführung und konstantem Durchmesser,
- **Fig. 5:**: eine Variante des Differenzstrom-Messmoduls mit zylindrischer Leitungsdurchführung und kegelförmiger Aufweitung,
- **Fig. 6:**: eine Montageleiterplatte mit Schlitzung für einen kreuzförmig ausgebildeten Trennsteg und mit Lötpads und
- **Fig. 7:**: das Differenzstrom-Messmodul mit Steckkontakten an den Primärleiterenden.

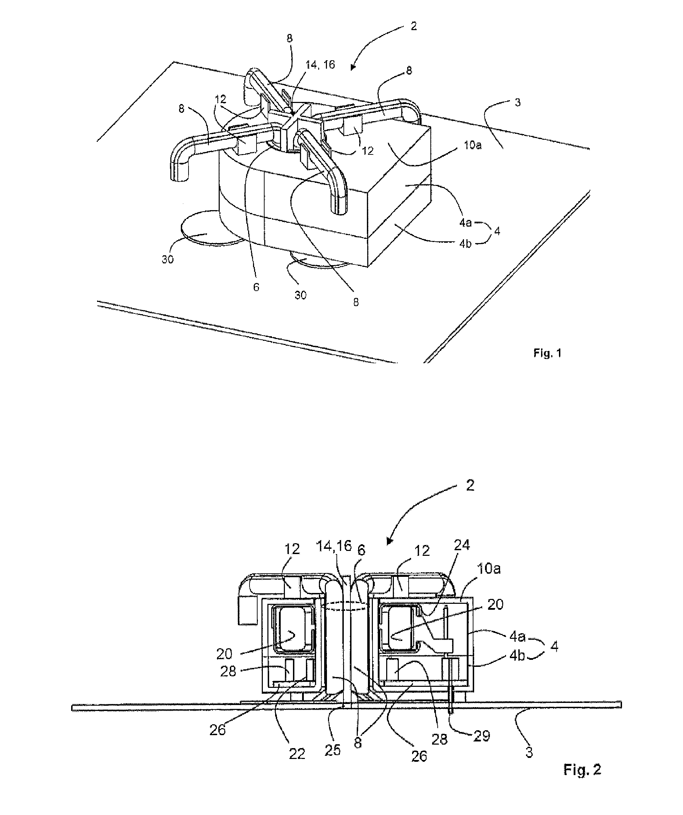

Die **Fig. 1** zeigt eine Außenansicht eines erfindungsgemäßen Differenzstrom-Messmoduls 2, das auf einer Montage-Leiterplatte 3 montiert ist. Das Differenzstrom-Messmodul 2 stellt ein integriertes Bauelement zur Differenzstrommessung dar, mit dem die Montage-Leiterplatte 3 bestückt werden kann.

In dem dargestellten Ausführungsbeispiel besteht das Differenzstrom-Messmodul 2 aus einem zweigeteilten Gehäuse 4 mit einem Gehäuseoberteil 4a und einem Gehäuseunterteil 4b. Das Gehäuse 4 weist eine zylindrische Leitungsdurchführung 6 auf, in der vier Primärleiter 8 als Bestandteil des Differenzstrom-Messmoduls 2 angeordnet sind.

Die vier Primärleiter 8 bilden somit Leitungsabschnitte, mit denen eine zu überwachende elektrische Zuleitung mit drei Phasenleitern (L1, L2, L3) und einem Neutralleiter (N) in der Leitungsdurchführung 6 zur Erfassung eines Differenzstroms fortgeführt wird.

Daneben ermöglicht die dargestellte vierpolige Ausführung in ein- oder zweiphasigen Stromversorgungssystemen mit hohen Strombelastungen eine Erhöhung des Primärstrombereichs auf den doppelten Wert durch Parallelschaltung je zwei der Primärleiter 8.

An einer Oberseite 10a des Gehäuses 4 sind die Primärleiter 8 in kreuzförmiger Anordnung rechtwinklig nach außen geführt und durch Klemmvorrichtungen 12 an der Oberseite 10a des Gehäuses 4 fixiert. Die Klemmvorrichtungen 12 sind als Schnappelemente ausgebildet.

In der Leitungsdurchführung 6 ist ein parallel zu der Leitungsdurchführung 6 verlaufender Trennsteg 14 zur Abstandshaltung der Primärleiter 8 angeordnet. Der Trennsteg 14 besteht aus vier kreuzförmig zueinander angeordneten Stegwänden 16, so dass die Leitungsdurchführung 6 in vier getrennte Leiterkanäle aufgeteilt ist, in denen jeweils ein Primärleiter 8 isoliert geführt ist.

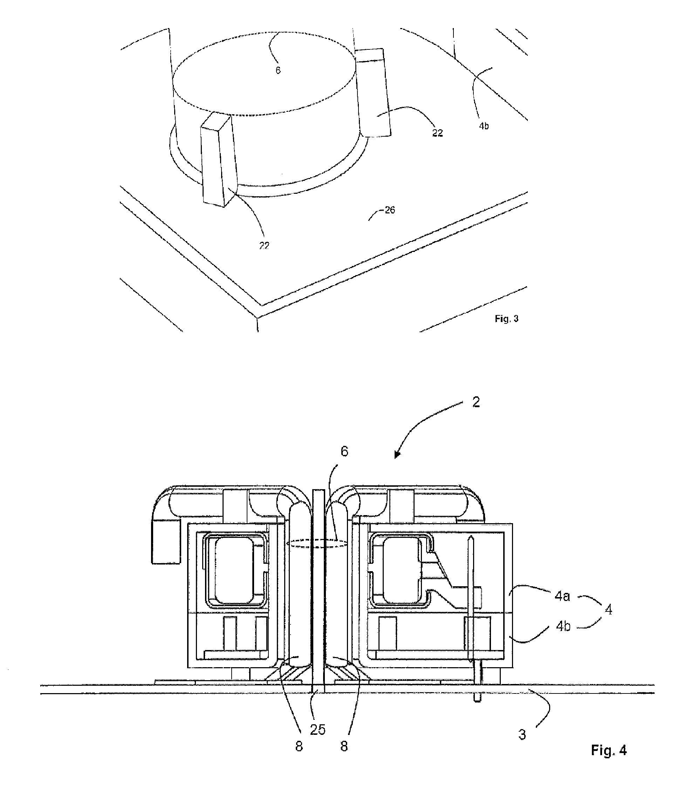

In **Fig. 2** ist ein Innenaufbau des Differenzstrom-Messmoduls 2 im Querschnitt dargestellt. Zu sehen ist der von einem Wandlerschirmgehäuse 24 umgebene Stromwandlerkern 20 in dem Gehäuseoberteil 4a. Der Stromwandlerkern 20 ist auf Stützauflagen 22 gelagert. Eine Detailansicht der Stützauflagen 22 zeigt **Fig. 3****.**

Wie **Fig. 2** weiter zeigt, ragt der Trennsteg 14 mit seinen Stegwänden 16 über eine Unterseite 10b des Gehäuses 4 hinaus, und greift in eine Schlitzung 25 der Montage-Leiterplatte 3 ein.

Der unter dem Stromwandlerkern 20 zwischen Gehäuseboden und dem Stromwandlerkern 20 verbleibende Bauraum wird genutzt, um eine Leiterplatine 26 mit elektronischen Bauelementen 28 in dem Gehäuse 4 anzuordnen. Die Leiterplatine 26 weist eine Ausstanzung in Form des Querschnitts der Leitungsdurchführung 6 auf, sodass die Leitungsdurchführung ringförmig von der Leiterplatine 26 umschlossen wird. Die Leiterplatine 26 ist mit elektronischen Bauelementen 28 bestückt, die eine Auswerteschaltung zur Verarbeitung eines von einer Sekundärwicklung (nicht dargestellt) des Stromwandlerkerns 20 gelieferten Messsignals bilden.

An der Unterseite des Gehäuses 4 angeordnete Stiftkontakte 29 stellen eine Kontaktierung zu der Montage-Leiterplatte 3 her.

Diese Anordnung ermöglicht ebenso wie eine Anbringung der Auswerteschaltung auf einer flexiblen Leiterplatte eine kompakte und platzsparende Ausführung des Differenzstrom-Messmoduls 2.

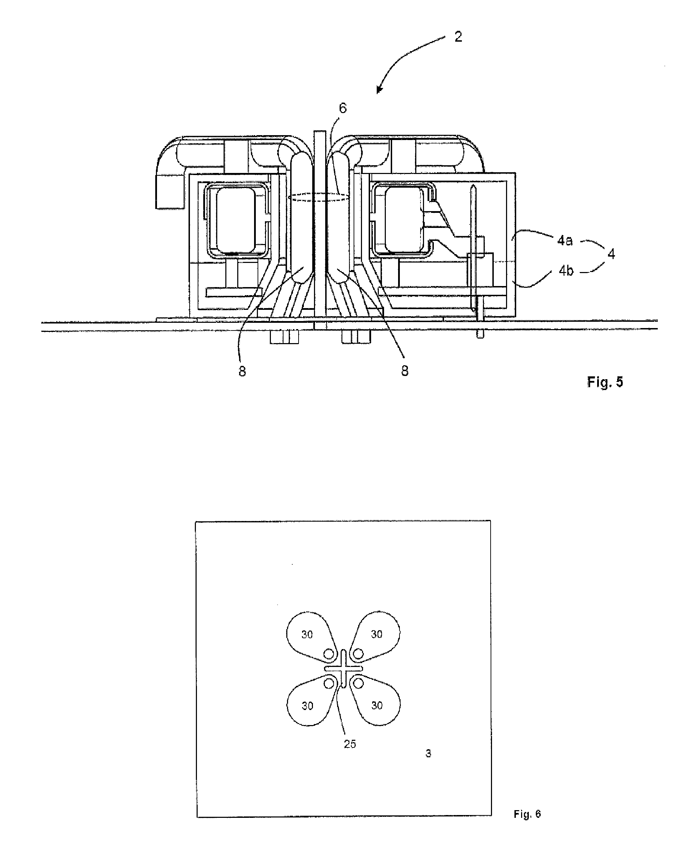

Die **Fig. 4** und die **Fig. 5** stellen eine Variante des Differenzstrom-Messmoduls 2 mit zylindrischer Leitungsdurchführung 6 und konstantem Durchmesser (Fig. 4) sowie eine Variante des Differenzstrom-Messmoduls 2 mit zylindrischer Leitungsdurchführung 6 und kegelförmiger Aufweitung (Fig. 5) dar. Im Fall der kegelförmigen Aufweitung der Leitungsdurchführung 6 ist der Innendurchmesser des Gehäuseunterteils 4b an dem unteren Auslass der Leitungsdurchführung 6 gegenüber dem mit konstantem Durchmesser ausgeführten Gehäuseunterteil 4b aus Fig. 4 vergrößert, sodass die Primärleiter 8 in größerem Abstand zueinander radial abgewinkelt auf die Montage-Leiterplatte 3 geführt werden können. Dies ermöglicht eine vorteilhafte Vergrößerung der Luft- und Kriechstrecken im Vergleich zu der Ausführung mit konstantem Durchmesser, sodass auf einen in die Montage-Leiterplatte 3 hineinragenden Trennsteg 14 und auf eine Schlitzung 25 der Montage-Leiterplatte 3 verzichtet werden kann.

Die **Fig. 6** zeigt eine Montage-Leiterplatte 3 mit Schlitzung 25 für einen kreuzförmig ausgebildeten Trennsteg 14 und mit Lötpads 30 zur Verlötung der Primärleiter 8. Die Lötpads 30 sind zur Optimierung der Luft- und Kriechstrecken sowie zur Maximierung des Leiterquerschnittes im Bereich des Übergangs der Primärleiter 8 auf die Montage-Leiterplatte 3 tropfenförmig ausgeprägt. Die Schlitzung 25 der Montage-Leiterplatte 3 führt ebenfalls zu einer Vergrößerung der Kriechstrecken.

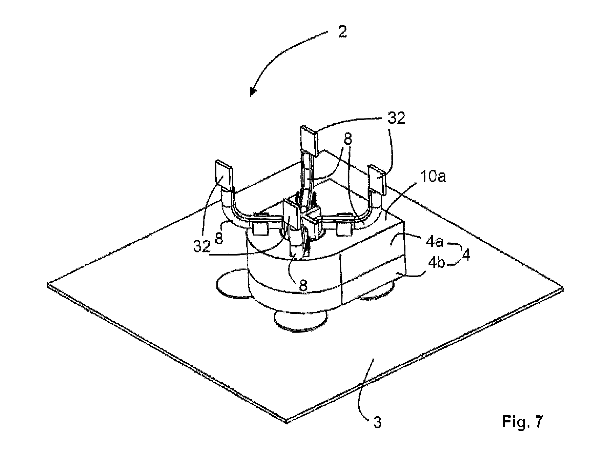

In **Fig. 7** ist das Differenzstrom-Messmodul 2 mit Primärleitern 8 dargestellt, die an ihren an der Oberseite 10a des Gehäuses 4 herausgeführten Enden jeweils mit einem Steckkontakt 32 versehen sind. Mit den Steckkontakten 32 kann in einfacher Weise eine lösbare elektrische Verbindung mit der zu überwachenden Zuleitung hergestellt werden.

## Patentansprüche

1. Differenzstrom-Messmodul (2) bestehend aus einem Gehäuse (4), das einen Stromwandlerkern (20) und eine Leiterplatine (26) umgibt, wobei der Stromwandlerkern (20) eine Leitungsdurchführung (6) des Gehäuses (4) umschließt und mindestens eine Sekundärwicklung aufweist,
**dadurch gekennzeichnet,**
**dass** in der Leitungsdurchführung (6) mindestens ein Primärleiter (8) angeordnet ist, der zum Anschluss an eine äußere elektrische Zuleitung auf einer Oberseite (10a) des Gehäuses (4) herausgeführt ist und dessen anderes Ende aus einer Gehäuseunterseite (10b) herausragt und mit einem Lötanschluss versehen ist.

2. Differenzstrom-Messmodul (2) nach Anspruch 1,
**dadurch gekennzeichnet,**
**dass** in der Leitungsdurchführung (6) ein parallel zu der Leitungsdurchführung (6) verlaufender Trennsteg (14) zur Abstandshaltung des Primärleiters (8) angeordnet ist.

3. Differenzstrom-Messmodul (2) nach Anspruch 2,
**dadurch gekennzeichnet,**
**dass** der in der Leitungsdurchführung (6) angeordnete Trennsteg (14) aus vier kreuzförmig zueinander angeordneten Stegwänden (16) besteht, so dass die Leitungsdurchführung (6) in vier getrennte Leiterkanäle aufgeteilt ist, in denen jeweils ein Primärleiter (8) isoliert geführt ist.

4. Differenzstrom-Messmodul (2) nach Anspruch 2 oder 3,
**dadurch gekennzeichnet,**
**dass** der Trennsteg (14) über die Oberseite (10a) des Gehäuses (4) hinausragt, sodass der Primärleiter (8) oberhalb des Gehäuses (4) isoliert nach außen gerichtet weiterführbar ist.

5. Differenzstrom-Messmodul (2) nach einem der Ansprüche 2 bis 4,
**dadurch gekennzeichnet,**
**dass** der Trennsteg (14) über die Unterseite (10b) des Gehäuses hinausragt.

6. Differenzstrom-Messmodul (2) nach einem der Ansprüche 2 bis 5,
**dadurch gekennzeichnet,**
**dass** der Trennsteg (14) als separates, in die Leitungsdurchführung (6) des Gehäuses (4) einsetzbares und herausnehmbares Bauteil ausgeführt ist.

7. Differenzstrom-Messmodul (2) nach einem der Ansprüche 1 bis 6,
**dadurch gekennzeichnet,**
**dass** an der Oberseite (10a) des Gehäuses (4) Klemmvorrichtungen (12) zur Befestigung des rechtwinklig aus der Leitungsdurchführung (12) herausgeführten Primärleiters (8) angebracht sind.

8. Differenzstrom-Messmodul (2) nach einem der Ansprüche 1 bis 7,
**dadurch gekennzeichnet,**
**dass** die Leitungsdurchführung (6) des Gehäuses (4) an der Unterseite (10b) des Gehäuses (4) eine kegelförmige Aufweitung aufweist, sodass die Primärleiter (8) radial nach außen abgewinkelt mit vergrößertem Abstand positionierbar sind.

9. Differenzstrom-Messmodul (2) nach einem der Ansprüche 1 bis 8,
**dadurch gekennzeichnet,**
**dass** das Gehäuse (4) ein Gehäuseoberteil (4a) und ein Gehäuseunterteil (4b) aufweist, die mittels einer Rastverbindung miteinander verbindbar sind.

10. Differenzstrom-Messmodul (2) nach einem der Ansprüche 1 bis 9,
**dadurch gekennzeichnet,**
**dass** das Gehäuse (4) ein einteiliges vergossenes Gehäuse ist.

11. Differenzstrom-Messmodul (2) nach einem der Ansprüche 1 bis 10,
**dadurch gekennzeichnet,**
**dass** der Stromwandlerkern (20) zur gehäuseinternen Positionierung auf Stützauflagen (22) gelagert ist.

12. Differenzstrom-Messmodul (2) nach einem der Ansprüche 1 bis 11,
**dadurch gekennzeichnet,**
**dass** von einer auf der Leiterplatine (26) angeordneten Auswerteschaltung erzeugte Ausgangssignale über Stiftkontakte (29) an der Unterseite des Gehäuses (4) herausgeführt sind.

13. Differenzstrom-Messmodul (2) nach einem der Ansprüche 1 bis 12,
**dadurch gekennzeichnet,**
**dass** der Primärleiter (8) an dem an der Oberseite (10a) des Gehäuses (4) herausgeführten Ende mit einem Steckkontakt (32) versehen ist.

14. Differenzstrom-Messmodul (2) nach Anspruch 13,
**dadurch gekennzeichnet,**
**dass** der mit dem Steckkontakt (32) versehene Primärleiter (8) als separate, in die Leitungsdurchführung (6) des Gehäuses (4) einsetzbare und herausnehmbare bauliche Einheit ausgeführt ist.

15. Differenzstrom-Messmodul (2) nach Anspruch 14,
**gekennzeichnet durch**
ein Steckergehäuse, **durch** das die Steckkontakte (32) der Primärleiter (8) hindurchragen und mit einem Gegenstecker kontaktiert werden können.
